# FASCICULE DE BREVET EUROPEEN

(11) **EP 2 714 961 B1**
(45) Date de publication et mention de la délivrance du brevet: **02.01.2019**
(21) Numéro de dépôt: 12723492.0
(22) Date de dépôt: 24.05.2012
(51) Int. Cl.: C23C 16/40, C23C 16/503, C23C 16/34, C03C 17/00, C03C 17/36

(54) **PROCEDE DE DEPOT DE COUCHES SUR UN SUBSTRAT VERRIER PAR PECVD A FAIBLE PRESSION**
VERFAHREN ZUR ABSCHEIDUNG VON SCHICHTEN AUF EINEM GLASSUBSTRAT MITTELS NIEDERDRUCK-PECVD
METHOD FOR DEPOSITING LAYERS ON A GLASS SUBSTRATE BY MEANS OF LOW-PRESSURE PECVD

(30) Priorité: 25.05.2011 BE 201100322
(43) Date de publication de la demande: 09.04.2014
(73) Titulaire: AGC Glass Europe, 1348 Louvain-la-Neuve (BE)
(72) Inventeur: MAHIEU, Stijn, B-6040 Jumet (BE); TIXHON, Eric, B-6040 Jumet (BE); VAN STUYVENBERG, Martin, B-6040 Jumet (BE); WIAME, Hugues, B-6040 Jumet (BE)
(74) Mandataire: Agustsson, Sveinn Otto
(86) Numéro de dépôt international: PCT/EP2012/059734
(87) Numéro de publication internationale: WO 2012/160145

(56) Documents cités:
- WO-A1-2010/017185
- WO-A2-2011/029096
- GEORGE M A, CHANDRA H, MÓRSE P, MADOCKS J: "Latest innovations in large area web coating technology via plasma enhanced chemical vapor deposition source technology", JOURNAL OF VACUUM SCIENCE AND TECHNOLOGY A, vol. 27, no. 4, juillet 2009 (2009-07), pages 970-974, XP002665793, USA ISSN: 0734-2101, DOI: 10.1116/1.3077287
- MADOCKS J ET AL: "Packaging barrier films deposited on PET by PECVD using a new high density plasma source", MATERIALS SCIENCE AND ENGINEERING B, ELSEVIER SEQUOIA, LAUSANNE, CH, vol. 119, no. 3, 15 juin 2005 (2005-06-15) , pages 268-273, XP025304619, ISSN: 0921-5107, DOI: 10.1016/J.MSEB.2004.12.080 [extrait le 2005-06-15]
- HOWELLS ET AL: "High quality plasma enhanced chemical vapour deposited silicon oxide gas barrier coatings on polyester films", THIN SOLID FILMS, ELSEVIER-SEQUOIA S.A. LAUSANNE, CH, vol. 516, no. 10, 17 novembre 2007 (2007-11-17), pages 3081-3088, XP022500306, ISSN: 0040-6090
- HARIPIN CHANDRA ET AL: "Low temperature plasma chemical vapor deposition (PCVD) of fluorinated tin-oxide transparent conducting oxide", PHOTOVOLTAIC SPECIALISTS CONFERENCE (PVSC), 2009 34TH IEEE, IEEE, PISCATAWAY, NJ, USA, 7 juin 2009 (2009-06-07), pages 1519-1522, XP031626629, ISBN: 978-1-4244-2949-3
- QUANYUAN SHANG ET AL: "N-type and P-type C-SI surface passivation by remote PECVD AlO<inf>x</inf> for solar cells", 2010 35TH IEEE PHOTOVOLTAIC SPECIALISTS CONFERENCE, 1 juin 2010 (2010-06-01), pages 003141-003144, XP055014857, DOI: 10.1109/PVSC.2010.5615839 ISBN: 978-1-42-445890-5
- M. GEORGE ET AL: "Silicon nitride ARC thin films by new plasma enhanced chemical vapor deposition source technology", 2008 33RD IEEE PHOTOVOLATIC SPECIALISTS CONFERENCE, 1 mai 2008 (2008-05-01), pages 1-5, XP055014854, ISSN: 0160-8371, DOI: 10.1109/PVSC.2008.4922785 ISBN: 978-1-42-441640-0
- MADOCKS J ET AL: "Large Area Plasma Enhanced Chemical Vapor Deposition of SiO2 on Glass and Plastic", SOCIETY OF VACUUM COATERS. ANNUAL TECHNICAL CONFERENCE PROCEEDINGS, SOCIETY OF VACUUM COATERS, US, no. 50ST, 1 January 2007 (2007-01-01), pages 233-238, XP003032681, ISSN: 0737-5921

## Description

La présente invention se rapporte à un procédé de dépôt de couches sur un substrat verrier par PECVD à faible pression en utilisant des précurseurs de type organométalliques.

Le dépôt de couches, telles que SiO₂ et TiO₂, par la technique de pulvérisation cathodique, notamment la pulvérisation magnétron, présente l'avantage d'autoriser l'obtention de couches minces de composés sous la forme par exemple de polycristaux. Cet avantage rend cette technique très répandue dans le domaine verrier et elle présente également une compatibilité avec les procédés de la microélectronique.

Des études récentes ont montré que la technique de PECVD ("Plasma Enhanced Chemical Vapour Déposition") présente des intérêts croissants dans le monde industriel, notamment verrier.

La PECVD est issue de la CVD (dépôt chimique en phase vapeur). La CVD consiste à envoyer, sur un substrat chaud, des réactifs chimiques ou précurseurs, préalablement vaporisés et qui se décomposent par pyrolyse au contact du substrat chaud. Ce procédé est couramment appliqué "on-line" lors de la production du verre flotté. On obtient ainsi des couches minces (de l'ordre de quelques nanomètres à des centaines de nm), notamment d'oxydes. Les couches obtenues sont denses, d'une grande pureté et généralement très stables chimiquement ainsi que mécaniquement. Les vitesses de dépôt sont élevées.

Cependant, la gamme de matériaux pouvant être déposés par CVD est limitée car il est difficile de trouver des précurseurs volatilisables et qui vont pyrolyser dans la gamme de températures accessibles aux verriers (500-750°C). Une possibilité de s'affranchir de la température du substrat et donc d'élargir la gamme des précurseurs utilisables en CVD et, par conséquent, la gamme de matériaux pouvant être déposés, est de combiner la CVD classique, éventuellement à plus basse température, avec un dispositif plasma.

La PECVD peut s'effectuer à l'aide de n'importe quel plasma : plasmas froids (hors équilibre) ou plasmas thermiques (en équilibre). Les plasmas froids sont généralement préférés. Les espèces actives du plasma, telles que électrons, ions, radicaux, présentent typiquement des énergies de plusieurs électronvolts (eV) et peuvent ainsi provoquer la dissociation ou l'activation des précurseurs chimiques. Pour maintenir le plasma hors équilibre, il est souvent nécessaire de travailler à pression réduite. La plupart des techniques connues de PECVD utilisent donc des plasmas à basse pression.

Le plasma peut être généré par l'intermédiaire de sources mettant en oeuvre des dispositifs connus et disponibles dans le commerce. Les sources de plasma doivent de préférence assurer une mise en oeuvre sur une gamme large en pression et sur un panel aussi large que possible de substrats à revêtir, produire un faisceau dense à haut rendement, éviter un encrassement de la source et l'utilisation de sources d'électrons à base de filaments. On peut citer, comme sources de plasma, les sources PBS (Plasma Beam Source), les sources PDP (Penning Discharge Plasma) et les sources microondes. Au sein des sources PBS, on peut citer les sources de plasma à cathode creuse (voir par exemple WO2010/017185) et les sources doubles faisceaux de plasma linéaires (Dual Beam PBS™) provenant notamment de GPi (General Plasma Inc.) (voir par exemple H. Chandra et al, GPi, "Recent Development of Low Temperature PECVD of Transparent Conducting Oxide in photovoltaic applications", pp.1-4, disponible en ligne sur le site web www.generalplasma.com ; J. Madocks et al, Material Science and Engineering B 119, (2005), 268-273 ; J. Madocks et al, ICCG8-Braunschweig 2010 - proceedings, 139-143; US 2006/0177599 A1).

Par rapport à la pulvérisation magnétron, la PECVD donne accès à des plasmas ayant des températures plus basses, ce qui permet le dépôt de matériaux différents plus nombreux. De plus, les films présentent une adhérence suffisante sur le substrat pour autoriser des traitements post-dépôts, tels que la trempe ou le laminage, et ils peuvent être obtenus avec des épaisseurs plus grandes.

Comme mentionné plus haut, la technologie PECVD présente l'avantage notamment de permettre des dépôts de différentes couches, transparentes, semi-transparentes ou non transparentes, à base d'oxydes, nitrures, oxynitrures, oxycarbures de métaux ou de semi-conducteurs, tels que SiO₂, TiO₂, SnO₂, ZrO₂, Al₂O₃, dans, par exemple, des applications photovoltaïques, de contrôle solaire ou d'affichage. Cependant, les propriétés physiques, optiques et électriques désirées de telles couches dépendent de paramètres, tels que la nature des précurseurs utilisés, le débit des gaz selon le rapport molaire gaz réactif/précurseurs, la nature des gaz réactifs, les pressions de mises en oeuvre et les sources de plasma, telles que citées plus haut.

A titre d'exemple, des couches de SnO₂:F ont été produites par PECVD en utilisant comme source le "Dual PBS™", sur des substrats de plusieurs mètres de largeurs, en ligne, à une température T°C inférieure à 130°C, avec des vitesses de dépôts de 200-300 nm.m/min et une uniformité de film meilleure que 3%, c'est-à-dire que la variation d'épaisseur du film considéré sur toute la largeur du verre ne varie que de 3% au maximum. Ces films de SnO₂ :F présentent une "bulk" résistivité de 2,18.10⁻³ Ohm.cm à 130°C, valeur inférieure à celle généralement obtenue avec d'autres méthodes PECVD à la même température, d'excellentes propriétés électriques, du fait d'un taux résiduel en carbone inférieur à 1%, et optiques par une faible valeur du coefficient ε (coefficient d'extinction molaire), inférieure à 0,01 entre 400 et 1100 nm (H. Chandra et al, cité ci-dessus).

L'article de J. Madocks et al (ICCG8- Braunschweig 2010 - proceedings, 139-143) décrit une installation PECVD et les conditions pour le dépôt de couches barrière de SiO2 et leurs propriétés. Il y est montré que les couches de SiO₂ obtenues par cette méthode présentent des propriétés de barrière à la migration des ions sodium bien meilleures que des couches de SiO₂ fabriquées par pulvérisation magnétron. La mise en oeuvre qui y est décrite est en outre plus efficace car permettant de travailler avec des vitesses de dépôt plus rapides (> 150 nm.m/min), à une température inférieure à 50°C et permettant de travailler en ligne pour réaliser des dépôts à l'échelle industrielle. De plus, cet article décrit également les propriétés de films de TiO₂, notamment en mettant l'accent sur les qualités optiques accrues de ces films obtenus avec des vitesses de dépôt bien plus importantes qu'avec le magnétron.

Cependant, dans le cas de couches de SiO₂ et de TiO₂, on retrouve une proportion de contaminants, tels qu'à base de carbone ou d'hydrogène, ce qui peut poser des problèmes sur les propriétés du film lors du traitement thermique ultérieur comme la trempe du verre avec couche.

Dans l'article J. Madocks et al (Material Science and Engineering B 119, (2005), 268-273) mentionné plus haut, les propriétés de barrière à l'eau des couches de SiO₂ sur un substrat polymère (polyéthylène - PET) ont été mesurées. A cette fin, les conditions opératoires ont montré que les propriétés barrière à l'eau sont accrues lorsque le débit en O₂ (gaz réactif) est diminué, ce qui signifie que des propriétés de barrière à l'eau identiques peuvent être obtenues avec un film de SiO₂ ayant une épaisseur trois fois plus faible et ce plus le débit en O₂ est réduit, toutes choses étant égales par ailleurs. Toutefois, on observe des accroissements des teneurs en carbone dans ces films avec la diminution correspondante du débit de O₂. Cette observation va dans le sens de ce qui est déjà connu: plus la teneur en O₂ augmente, plus la teneur en carbone dans les films diminue, c'est-à-dire que plus de molécules de O₂ interagissent avec le carbone des précurseurs organiques.

Cependant, le débit de O₂ seul n'est pas suffisant pour réduire la teneur en carbone dans un film de SiO₂ par exemple. D'autres paramètres ont une influence sur celle-ci comme la puissance électrique appliquée sur les électrodes d'un dispositif PECVD, plus spécifiquement la densité de puissance du plasma, le débit et la nature des précurseurs de SiO₂, tels que le TMDSO (tétraméthyldisiloxane) et le HMDSO (hexaméthyldisiloxane), de TiO₂, tels que l'éthoxytitane, de SnO₂, tels que le tétraméthylétain, de Al₂O₃, tels que le triméthylaluminium, par rapport à la pression partielle de gaz réactif, tel que O₂. Par conséquent, ces paramètres déterminent les vitesses de dépôts (nm.m/min), car pour obtenir une vitesse de dépôt élevée, il est nécessaire que le débit de gaz de précurseurs soit élevé, ce qui conduit à choisir une faible pression partielle de gaz réactif aboutissant à une teneur en carbone non acceptable dans les couches.

Un des objectifs de la présente invention est d'obtenir des dépôts de couches d'oxydes, de nitrures ou d'oxynitrures de métaux ou semi-conducteurs, par la mise en oeuvre d'un procédé PECVD à basse pression, laquelle est typiquement comprise entre 0,5 et 0,001 Torr, permettant des vitesses de dépôts rapides et minimisant la quantité de contaminants provenant du précurseur.

L'invention concerne, dans un premier aspect, un procédé de production de films d'oxydes, de nitrures ou d'oxynitrures de métaux ou semi-conducteurs sur un substrat, par la méthode de PECVD comprenant les étapes consistant à :
a) se munir d'un dispositif de PECVD, à basse pression, comprenant au moins une source à doubles faisceaux linéaires de plasma, laquelle comprend au moins deux électrodes reliées à un générateur AC ou DC pulsé, pour le dépôt desdits films sur le substrat,
b) appliquer une puissance électrique entre les deux électrodes de façon telle que la densité de puissance du plasma soit comprise entre 5 et 50 W par cm² de plasma, et,
c) appliquer sur le substrat un précurseur gazeux de films d'oxydes, de nitrures ou d'oxynitrures de métaux ou semi-conducteurs à un débit compris entre 100 et 1000 sccm par mètre linéaire de la source de plasma, et un gaz réactif à base d'oxygène ou de dérivés oxygénés ou de dérivés azotés à un débit compris entre 500 et 20000 sccm par mètre linéaire de la source de plasma.

De manière alternative, l'invention concerne un procédé de production de films d'oxydes, de nitrures ou d'oxynitrures de métaux ou semi-conducteurs sur un substrat, par la méthode de PECVD comprenant les étapes consistant à :
a) se munir d'un dispositif de PECVD, à basse pression, comprenant au moins une source de plasma à cathode creuse, laquelle comprend au moins une électrode reliée à un générateur AC, DC ou DC pulsé, pour le dépôt desdits films sur le substrat,
b) appliquer une puissance électrique à la source de plasma de façon telle que la densité de puissance du plasma soit comprise entre 15 et 100 kW par mètre de plasma, et,
c) appliquer sur le substrat un précurseur gazeux de films d'oxydes, de nitrures ou d'oxynitrures de métaux ou semi-conducteurs à un débit compris entre 100 et 1000 sccm par mètre linéaire de la source de plasma, et un gaz réactif à base d'oxygène ou de dérivés oxygénés ou de dérivés azotés à un débit compris entre 500 et 20000 sccm par mètre linéaire de la source de plasma.

Le Demandeur a montré que, par la mise en oeuvre du procédé, il était possible d'obtenir des films de différents oxydes, nitrures ou oxynitrures de métaux ou semi-conducteurs dans lesquels des résidus provenant du précurseur sont présents dans des taux d'au plus 2%, voire d'au plus 0,5%, avantageusement d'au plus 0,1% atomique. Le Demandeur a trouvé que ceci n'est possible que par la combinaison nécessaire de la source PECVD reliée au générateur de l'étape a), des densités de puissance du plasma spécifiques et lorsque, de préférence, le rapport entre le débit de gaz réactif et le débit de précurseur gazeux est au minimum celui nécessaire à l'obtention desdits films. Grâce à cette faible teneur en résidus, les couches de ces oxydes, nitrures ou oxynitrures, lorsque déposées sur un substrat verrier, permettent de conserver voire d'optimiser les propriétés optiques, électriques et structurelles, telles que de barrière de migration des ions sodium, de contrôle du "haze", anti-rayures, anti-réfléchissantes, permettant de "rafraîchir" les surfaces de substrats verriers, et/ou d'assurer une trempe homogène et sans défauts du film ainsi déposé. Le procédé PECVD présente tous les avantages de mise en oeuvre énumérés ci-dessus : vitesse de dépôts élevées, typiquement de l'ordre d'au moins 100 nm.m/min., facilité de mise en oeuvre à l'échelle industrielle, excellente uniformité des couches obtenues (< 5%) et coût modéré des installations.

Dans le cadre de l'invention, on entend par résidus provenant du précurseur, tout atome présent dans la molécule de précurseur de départ et se retrouvant de manière non désirée dans le film.

La densité de puissance du plasma est définie comme étant la puissance dissipée dans le plasma généré au niveau de(s) électrode(s) rapportée à la taille du plasma.

Le "mètre linéaire de la source de plasma" appelé aussi ici "longueur totale du plasma" est défini comme la distance entre les extrémités du plasma dans la direction de la largeur du substrat à revêtir.

Pour une source à doubles faisceaux linéaires de plasma, la "densité de puissance du plasma" peut être définie comme la puissance totale appliquée à la source, divisée par la surface totale du plasma, elle-même définie comme la surface parallèle au substrat emplie du plasma provenant de la source de plasma, et calculée en multipliant la longueur totale du plasma par sa largeur totale. La "largeur totale du plasma" est définie comme la distance entre les extrémités du plasma dans la direction de défilement du substrat à revêtir.

Pour une source de plasma à cathode creuse, la "densité de puissance du plasma" peut être définie comme la puissance totale appliquée à la source, divisée par la longueur totale du plasma.

De façon plus spécifique, le rapport molaire de gaz réactif/précurseur gazeux, est avantageusement, pour les films de type M^{(x)}O_{x/2}, supérieur ou égal à (x/2 - y)/z, x étant la valence de l'oxyde métallique à obtenir, y étant le nombre d'atomes d'oxygène présent dans le précurseur de départ et z étant le nombre d'atomes d'oxygène présent dans le gaz réactif.

De même, le rapport molaire des gaz, pour les films de type M^{(x)}N_{x/3}, est avantageusement supérieur ou égal à (x/3 - y)/z, x étant la valence du nitrure métallique à obtenir, y étant le nombre d'atomes d'azote présent dans le précurseur de départ et z étant le nombre d'atomes d'azote présent dans le gaz réactif.

L'étape a) du procédé nécessite un dispositif PECVD à basse pression, laquelle est de préférence comprise entre 0,001 et 0,5 Torr, de façon préférée entre 1 et 30 mTorr, et, de façon plus préférée, entre 3 et 20 mTorr, muni d'une source à doubles faisceaux linéaires de plasma ou d'une source de plasma à cathode creuse, reliée à un générateur AC ou DC pulsé, dont les fréquences sont habituellement comprises entre 5 et 150 kHz, de préférence entre 5 et 100 kHz, ou à un générateur DC (ce dernier uniquement dans le cas d'une source à cathode creuse).

Des dispositifs PECVD à source doubles faisceaux linéaires de plasma qui conviennent particulièrement à l'invention sont disponibles dans le commerce et peuvent provenir, par exemple, de la Société GPi (General Plasma Inc - USA). Il s'agit de sources à doubles faisceaux linéaires de plasma reliées à un générateur AC ou DC pulsé. De telles sources sont également disponibles dans le commerce sous le vocable "Dual Beam PBS™" (Plasma Beam Source). Alternativement, des dispositifs PECVD à source de plasma à base de cathode creuse ("hollow cathode"), laquelle est également reliée aux générateurs mentionnés plus haut, conviennent également particulièrement à l'invention.

Un exemple de dispositif PECVD est décrit ci-après. La source PECVD est connectée sur une chambre sous vide. Cette chambre sous vide est agencée de telle façon qu'elle permet d'avoir les unes à côté des autres différentes sources ayant des modes de dépôt différents. Habituellement, ces sources, permettant des modes de dépôt différents, sont des cathodes plates ou rotatives pour des dépôts de pulvérisation magnétron. Un couvercle spécifique a été fabriqué de façon à permettre l'installation de la source PECVD à une position où habituellement une source magnétron de pulvérisation est installée. Ce type de chambre sous vide ou "coater" est agencé pour réaliser des dépôts de couches complexes (empilages) sur des substrats de grandes dimensions, par exemple une plaque de verre de 3,21 m de large et de 6 mètres de long, en déplaçant le substrat successivement sous les sources de dépôt. En tant que telle, cette chambre sous vide ainsi modifiée permet des dépôts de couches complexes combinant des dépôts par pulvérisation magnétron et par PECVD sur des substrats de grande dimension.

La source PECVD utilisée peut être constituée d'une source à doubles faisceaux linéaires de plasma, comprenant deux cavités dans lesquelles a lieu la décharge et d'ouvertures d'où elle est expulsée. Chaque cavité est reliée à une conduite qui permet d'introduire dans la cavité un gaz qui sera ionisé, et inclut une électrode connectée à un générateur de puissance qui débite soit du courant alternatif (AC) soit du DC pulsé. L'électrode est apte à supporter au moins une décharge magnétron dans la cavité. Dans la source de plasma se trouve une série d'aimants qui se font face et qui bordent la cavité. Ces aimants sont disposés de façon à créer un point de champ magnétique nul dans la cavité où se produit la décharge. Les électrodes de chaque cavité étant reliées au générateur AC, alternativement, à chaque demi-cycle, elles sont soit l'anode soit la cathode. Le gaz injecté dans chaque cavité est ainsi ionisé et forme un faisceau d'ions, il forme ce que l'on appelle une source de plasma qui est émis hors de la source par une ouverture en direction du substrat.

Alternativement, la source PECVD utilisée peut être constituée d'une cathode creuse comprenant, par exemple, deux cavités formant deux électrodes reliées à un générateur AC ou DC pulsé, dans lesquelles a lieu la décharge et d'ouvertures d'où elle est expulsée. Chaque cavité est reliée à une conduite qui permet d'introduire dans la cavité un gaz qui sera ionisé.

Le gaz ionisable est généralement de l'O₂ ou un mélange O₂/Ar pour le dépôt d'oxydes, de l'azote (N₂) ou un mélange N₂/Ar pour le dépôt de nitrures, un mélange de N₂/O₂ ou N₂/O₂/Ar pour le dépôt d'oxynitrures. La fréquence du générateur de puissance est habituellement comprise entre 5 et 150 kHz, de préférence entre 5 et 100 kHz. En dehors de la source de plasma, le gaz précurseur condensable est injecté de façon uniforme le long de la source de plasma. Ce gaz précurseur est activé par ce plasma. Le substrat est amené à proximité de la source et une couche mince est déposée sur le substrat au départ du gaz activé. La quantité de gaz ionisable introduite dans la cavité est contrôlée par des débitmètres massiques qui sont placés sur la conduite entre le réservoir de gaz et la source plasma. La quantité de gaz précurseur injecté dans le plasma et le débit d'ions sont contrôlés par un débitmètre massique liquide/vapeur. La gamme de pression de travail pour la source plasma est habituellement comprise entre 1 et 500 mTorr. Le pompage est assuré préférentiellement par des pompes turbos-moléculaires. Pour obtenir une bonne uniformité du dépôt sur le substrat, un pompage vers le haut à travers la source est préféré.

De préférence, le rapport entre le débit de gaz réactif et le débit de précurseur gazeux est d'au moins 5, avantageusement compris entre 5 et 30.

La température à laquelle le substrat est porté est comprise entre 20°C et 550°C. Le substrat est très avantageusement un substrat verrier habituel, tel qu'un verre clair, extra-clair ou coloré, d'épaisseur variable. Il peut également s'agir de substrats métalliques, tels que l'acier, ou des polymères, tels que polymères de dérivés de polyéthylène. Dans le contexte de l'invention, il peut également s'agir d'un substrat qui est déjà préalablement revêtu par une autre couche, tel que dans le cas d'un empilage sur un substrat destiné au contrôle solaire, aux utilisations photovoltaïques, décoratives (par exemple, des miroirs), architecturales et automobiles. Ainsi, les couches selon l'invention peuvent avantageusement être utilisées en tant que couche la plus extérieure d'un empilage, ou au sein de l'empilage ou directement sur le verre afin, par exemple, de conférer au substrat ainsi revêtu des propriétés anti-réfléchissantes et anti-rayures, de contrôle du "haze" ou de couche barrière.

De préférence, les films d'oxydes, de nitrures ou d'oxynitrures de métaux ou semi-conducteurs sont choisis dans le groupe constitué par SiO₂, TiO₂, SnO₂, ZrO₂, Al₂O₃, AlN, TiN, ZnO, nitrure de silicium, TaN, WO₃, Cr₂Oₓ, x étant compris entre 3 et 6, et CrN, lesdits composants pouvant être dopés, ainsi que les alliages de ces composants ou d'autres, contenant au plus 2% atomique de résidus de précurseurs, notamment choisis dans le groupe constitué par H, C, Cl, dérivés de CHₓ, dérivés de NHₓ et dérivés de OHₓ, x étant compris entre 1 et 4. Quelle que soit la nature du résidu, celui-ci est présent dans une quantité d'au plus 2% atomiques par rapport au nombre total d'atomes métalliques du film, avantageusement d'au plus 0,5%, et très avantageusement d'au plus 0,1%. La détermination de ce taux est effectuée de préférence par spectroscopie de photoélectrons XPS ou par spectrométrie de masse à ionisation secondaire SIMS; elle peut également être effectuée par spectroscopie Raman, par des techniques d'analyse « ion beam analysis », telles que NRA et RBS, et autres.

Préférentiellement, à l'étape a), la source du dispositif PECVD a des dimensions comprises entre de 250 mm et 4000 mm de longueur et entre 100 et 800 mm de largeur, fournissant une puissance comprise entre 5 kW par mètre linéaire de la source de plasma et 50 kW, avantageusement entre 10 et 35 kW par mètre de la source de plasma.

A l'étape b), dans le cas d'une source à doubles faisceaux linéaires de plasma, on applique une densité de puissance entre les deux électrodes de façon telle que la densité de puissance soit comprise entre 5 et 50 W par cm² de plasma. En deçà de cette densité de puissance de 5 W par cm² de plasma, on observe une présence importante de résidus de précurseurs, et au-delà de 50 W par cm² de plasma, on observe la formation de poudre en phase gazeuse portant préjudice à la qualité du dépôt.

A l'étape b), dans le cas d'une source de plasma à cathode creuse, on applique une densité de puissance entre les deux électrodes de façon telle que la densité de puissance soit comprise entre 15 et 100 kW par mètre de plasma, de préférence entre 15 et 60 kW par mètre de plasma. En deçà de cette densité de puissance de 15 kW par m de plasma, on observe une présence importante de résidus de précurseurs, et 15 et 60 kW par mètre de plasma. En deçà de cette densité de puissance de 15 kW par m de plasma, on observe une présence importante de résidus de précurseurs, et au-delà de 100 kW par m de plasma, voire parfois même au-delà de 60 kW par m de plasma, on observe la formation de poudre en phase gazeuse portant préjudice à la qualité du dépôt.

Les précurseurs organiques de l'étape c) dépendent de la nature de la couche qui va être déposée. Ce sont des produits volatils en particulier dans les températures de mise en oeuvre du procédé. Les précurseurs de SiO₂ sont typiquement le SiH₄ (silane), le TMDSO (tétraméthyldisiloxane) et le HMDSO (hexaméthyldisiloxane); de TiO₂, l'éthoxytitane, le TTIP (tétra-isopropoxyde de titane); de SnO₂, les alkyles d'étain, tel que le tétraméthylétain, le chlorure d'étain (SnCl₄), les organo-chlorés d'étain, tels le MBTC (monobutyl-trichlorure d'étain); de Al₂O₃, les alkyl-aluminium, tel que le triméthylaluminium; de ZnO, les akyles de zinc, tel que le diéthyl zinc; cette liste n'étant pas exhaustive. Selon les cas, le précurseur peut en outre comprendre un précurseur complémentaire, par exemple pour inclure un dopant spécifique, tel que l'antimoine ou le fluor, dans une couche typiquement de SnO₂. Un tel précurseur complémentaire peut être SF6 pour le fluor, et un composé organo-chloré pour l'antimoine.

Le débit du précurseur gazeux est compris entre 100 et 500 sccm (« standard cubic centimeters per minute ») par mètre linéaire de la source de plasma, préférentiellement entre 150 et 500 ou entre 200 et 500 sccm par mètre linéaire de la source de plasma. Cette gamme est nécessaire pour l'obtention de taux de dépôt importants propre à cette technique, de l'ordre de 100 à 400 nm.m/min.

Le gaz réactif est à base d'oxygène ou de dérivés oxygénés, ces derniers étant de préférence choisis dans le groupe constitué par l'ozone, l'eau oxygénée, l'eau, le CO₂, ou bien encore de dérivés azotés, de préférence choisis dans le groupe constitué par N₂, NH₃, N₂O, HCN. Selon des modes de réalisation, le gaz réactif peut en outre avantageusement inclure un gaz inerte, tel que l'hélium, l'azote, l'argon, le néon ou le krypton, afin de favoriser la dissociation chimique des précurseurs et de contrôler le bombardement ionique par la source. La proportion de gaz inerte dans le mélange total (gaz réactif-gaz inerte) est définie par le rapport entre le débit du gaz réactif et le débit inférieure à 0,5 nm, ce qui, pour une couche de SiO₂ avec, par exemple, une épaisseur entre 20 et 40 nm, peut sensiblement améliorer les propriétés de barrière.

Le débit du gaz réactif est compris entre 500 et 20000 sccm par mètre linéaire de la source de plasma, préférentiellement entre 800 et 20000 ou entre 1000 et 20000 sccm par mètre linéaire de la source de plasma. De telles valeurs ont l'avantage d'assurer une quantité de gaz réactif suffisamment supérieure à celle des précurseurs, permettant de fortement limiter, voire d'éliminer, l'incorporation de C dans la couche.

Les couches sont généralement fabriquées de sorte que leur épaisseur géométrique soit comprise entre 2 et 1500 nm, préférentiellement entre 20 et 800 nm, en particulier entre 30 et 600 nm. L'épaisseur choisie est fonction de l'effet technique désiré pour les substrats ainsi revêtus.

Les applications de ce procédé sont liées à la nature de la couche déposée sur le substrat. Ci-après sont décrits divers modes de réalisation de l'invention, pour différentes applications.

Selon un premier mode de réalisation, le procédé est mis en oeuvre pour la production d'un substrat verrier sur lequel est déposée en contact direct avec le substrat une couche de SiO₂, empêchant la migration des ions sodium à partir du verre (couche barrière). La teneur en carbone de cette couche doit être la plus faible possible, inférieure à 2% atomique, voire, avantageusement, inférieure à 0,1% atomique pour permettre la trempe du substrat. Ce faible taux de carbone limite, voire empêche, à l'issue de la trempe, l'apparition de défauts, tels que le "haze" non désiré, des craquelures et des bulles de CO₂ piégées dans le film. La couche ainsi obtenue présente une bonne densité mesurée par Ra, inférieure à 2 nm, dont l'épaisseur est comprise entre 10 et 40 nm. Habituellement, une telle couche est mise en oeuvre lors de la production de substrat verrier Low-E, avantageusement en ligne, une couche Low-E étant alors déposée sur la couche barrière de SiO₂. Les couches Low-E peuvent être le SnO₂:F, le SnO₂:Sb, l'ITO (oxyde d'indium dopé à l'étain) ou d'autres couches obtenues par magnétron, telles que les multicouches à base d'Ag. Le procédé est alors réalisé avec une densité de puissance supérieure à 5 W par cm² de plasma pour une source à double faisceaux linéaires de plasma ou supérieure à 15 kW par mètre de plasma pour une source de plasma à cathode creuse, la vitesse de dépôt étant inférieure à 400 nm.m/min, de préférence comprise entre 200 et 100 nm.m/min. Les pressions sont comprises entre 3 et 20 ou 3 et 15 mTorr. On utilise comme précurseur un dérivé organique de silane, tel que le TMDSO, et l'oxygène pur comme gaz réactif, le rapport entre le débit d' oxygène et le débit du dérivé organique de silane étant supérieur à 5, de préférence supérieur à 10, voire supérieur à 15, soit un débit d'oxygène de 1000 sccm pour une source linéaire de 250 mm de longueur, et un débit de précurseurs de 100 sccm. La source définie à l'étape a) du dispositif PECVD est de préférence placée avant le système de revêtement de couches ultérieures, telles que Low-E, lesquelles peuvent être déposées par pulvérisation magnétron ou par CVD. Les valeurs ci-dessus de Ra peuvent également être obtenues par l'ajout d'un gaz inerte de sorte que le rapport entre le débit des gaz réactifs et le débit du gaz inerte est d'au moins 5, avantageusement compris entre 5 et 30, de préférence entre 5 et 20, plus préférentiellement entre 5 et 15, en particulier aux alentours de 8. En variante, les valeurs de Ra citées plus haut peuvent être obtenues en modifiant la tension de la cathode, ce qui peut être effectué par changement du matériau constitutif de l'électrode ou en adaptant les modules du générateur de puissance ou en modifiant la pression. On passe habituellement d'une tension d'environ 400 V à environ 340 V, voire 300 V. En variante encore, les valeurs de Ra désirées peuvent être obtenues en augmentant la pression jusqu'à des valeurs comprises entre 7 et 20 ou entre 7 et 15 mTorr, les valeurs de 9-10 mTorr étant celles qui donnent les meilleurs résultats.

Selon un deuxième mode de réalisation, le procédé est mis en oeuvre pour la production de couches de SiO₂ déposées soit directement sur un substrat verrier, soit dans un empilage avec d'autres couches en position quelconque, ou bien en tant que couche la plus extérieure d'un empilage pour le contrôle des valeurs de "haze" dans des empilages destinés aux applications solaires, telles que photovoltaïques, incorporant des couches Low-E. La couche doit nécessairement contenir un taux de carbone inférieur à 0,2%, et son épaisseur est typiquement de 2 à 100 nm. Selon les cas, des valeurs de "haze" élevées sont nécessaires pour favoriser l'effet photovoltaïque et améliorer le rendement de photoconversion. Dans d'autres applications, par exemple architecturales, il peut être requis des valeurs de "haze" les plus faibles possibles. Par l'adaptation des paramètres du procédé de l'invention, il requis des valeurs de "haze" les plus faibles possibles. Par l'adaptation des paramètres du procédé de l'invention, il peut être fourni une couche de SiO₂ conférant un "haze" élevé, d'au moins 5%, voire d'au moins 10-20%. À cette fin, la densité de puissance est d'au plus 10 W par cm² de plasma pour une source à double faisceaux linéaires de plasma ou d'au plus 20 kW par mètre de plasma pour une source de plasma à cathode creuse, le débit de précurseur gazeux d'un dérivé organique de silane, tel que TMDSO, est inférieur à 400 sccm par mètre linéaire de source plasma, préférentiellement compris entre 100 et 400 sccm par mètre linéaire de source plasma, le rapport entre le débit d'oxygène (gaz réactif) et le débit du précurseur gazeux est supérieur à 5, la vitesse de dépôt étant inférieure à 400 nm.m/min, de préférence comprise entre 300 et 200 nm.m/min. Pour de faibles "haze", typiquement inférieurs à 0,5%, la densité de puissance est d'au moins 5 W par cm² de plasma pour une source à double faisceaux linéaires de plasma ou d'au moins 15 kW par mètre de plasma pour une source de plasma à cathode creuse, la pression est supérieure à 5 mTorr, le débit de précurseur gazeux d'un dérivé organique de silane, tel que TMDSO, est inférieur à 400 sccm par mètre linéaire de source plasma, préférentiellement compris entre 100 et 400 sccm par mètre linéaire de source plasma, le rapport entre le débit d'oxygène (gaz réactif) et le débit du précurseur gazeux est supérieur à 15. La vitesse de dépôt étant inférieure à 400 nm.m/min, de préférence comprise entre 200 et 100 nm.m/min et idéalement inférieure à 100 nm/min.

Selon un troisième mode de réalisation, le procédé est mis en oeuvre pour la production de couches choisies dans le groupe constitué par SiO₂, ZrO₂ et Al₂O₃, déposées soit directement sur un substrat verrier, soit en tant que couche la plus extérieure d'un empilage dans le but de conférer des propriétés anti-rayures au substrat revêtu ou non. L'épaisseur de la couche, déposée directement sur le substrat verrier, est généralement comprise entre 100 et 1500 nm, avantageusement entre 200 et 1000 nm, la densité de puissance étant comprise entre 10 et 40 W par cm² de plasma pour une source à double faisceaux linéaires de plasma ou entre 20 et 50 kW par mètre de plasma pour une source de plasma à cathode creuse, la pression est inférieure à 10 mTorr, le débit de précurseur gazeux d'un dérivé organique de silane, tel que TMDSO, est compris entre 150 et 500 sccm par mètre linéaire de source plasma, le rapport entre le débit d'oxygène (gaz réactif) et le
supérieur à 10. La vitesse de dépôt étant inférieure à 400 nm.m/min, de préférence comprise entre 200 et 100 nm.m/min.

Des essais anti-rayures DBT (« Dry Brush Test ») réalisés sur 4000 cycles (ASTM D 2486) montrent, par exemple, des résultats bien meilleurs que pour un substrat verrier nu pour des couches de SiO₂ d'environ 20 nm. Lorsqu'une telle couche est déposée sur un substrat verrier préalablement revêtu d'une couche Low-E à base d'argent, l'épaisseur de cette couche de silice doit être de préférence supérieure à 40 nm, préférentiellement supérieure à 60 nm, avantageusement comprise entre 80 et 100 nm.

Selon un quatrième mode de réalisation, le procédé est mis en oeuvre pour la production d'empilages sur un substrat verrier présentant des propriétés anti-réfléchissantes (AR). On peut par exemple considérer un empilage comprenant une succession de couches de hauts indices de réfraction, telles que de TiO₂, et à bas indices de réfraction, telles que de SiO₂. SiO₂ est alors déposée par le procédé de l'invention, TiO₂ par pulvérisation magnétron. Ceci est possible grâce aux propriétés hautement transparentes de SiO₂, dont les épaisseurs sont celles classiquement utilisées dans cette application. L'absorption de la lumière dans le film de SiO₂ doit alors être inférieure à 1%, mieux encore inférieure à 0,5%, voire inférieure à 0,2%. Les conditions de procédé à choisir dans ce cas sont les suivantes. La densité de puissance est comprise entre 10 et 40 W par cm² de plasma pour une source à double faisceaux linéaires de plasma ou entre 20 et 50 kW par mètre de plasma pour une source de plasma à cathode creuse, la pression étant inférieure à 20 mTorr, le débit de précurseur gazeux d'un dérivé organique de silane, tel que TMDSO, est inférieur à 400 sccm par mètre linéaire de source plasma, préférentiellement compris entre 150 et 300 sccm par mètre linéaire de source plasma, le rapport entre le débit d'oxygène (gaz réactif) et le débit du précurseur gazeux est supérieur à 5 et idéalement supérieur à 15, la vitesse de dépôt étant inférieure à 400 nm.m/min, de préférence comprise entre 100 nm.m/min et 200 nm.m/min, ou encore mieux inférieure à 100 nm.m/min. Ceci garantit un taux de carbone dans la couche de SiO₂ inférieur à 2%, voire inférieur à 0,5% ou à 0,1%.

Pour cette même application (propriétés antiréfléchissantes), une couche de SiO₂ hautement transparente peut être déposée sur un substrat en verre lequel est revêtu d'une couche Low-E, comme celles décrites plus haut. Dans ce cas, on dépose la couche Low-E, par exemple, par pulvérisation magnétron et, la couche SiO₂, par le procédé de l'invention, avantageusement sur la même ligne. La réflexion côté couche est réduite de 10%, avantageusement réduite de 20-40%, par rapport à un empilage Low-E sans cette couche de SiO₂. Le procédé est alors réalisé avec une densité de puissance supérieure à 5 W/cm² de plasma pour une source à double faisceaux linéaires de plasma ou supérieure à 15 kW par mètre de plasma pour une source de plasma à cathode creuse, le débit de précurseur gazeux d'un dérivé organique de silane, tel que TMDSO, est inférieur à 400 sccm par mètre linéaire de source plasma, préférentiellement compris entre 100 et 300 sccm par mètre linéaire de source plasma, la vitesse de dépôt étant inférieure à 200 nm.m/min, de préférence inférieure à 150 nm.m/min, en particulier inférieure à 100 nm.m/min, la pression étant inférieure à 20 mTorr. On utilise comme précurseur gazeux un dérivé organique de silane, tel le TMDSO, et l'oxygène pur comme gaz réactif, le rapport entre le débit d'oxygène et le débit du précurseur gazeux étant supérieur à 5, voire supérieur à 15.

Selon un cinquième mode de réalisation, le procédé est mis en oeuvre pour "rafraîchir" la surface du verre. Dans le cas d'un dépôt par pulvérisation magnétron, l'état de fraîcheur de la surface du verre est un paramètre essentiel, surtout quand ensuite le verre revêtu de couches doit être trempé. Le verre ne doit pas présenter de traces d'irisation. Pour pallier cet inconvénient, un dépôt de SiO₂ exempt de carbone selon le procédé, directement sur le verre, est une solution appropriée pour rafraîchir la surface du verre et permettre l'utilisation de vieux verres comme supports de couches, telles que Low-E, selon la technique magnétron.

Ainsi, le dépôt d'une couche SiO₂ permet d'éviter ces inconvénients, avantageusement lorsque son épaisseur est comprise entre 20 et 60 nm. La rugosité du SiO₂ (Ra) doit être de préférence inférieure à 5 nm, de préférence encore inférieure à 2 nm, avantageusement inférieure à 0,5 nm.

Le procédé est alors réalisé avec une densité de puissance supérieure à 5 W/cm² de plasma pour une source à double faisceaux linéaires de plasma ou supérieure à 15 kW par mètre de plasma pour une source de plasma à cathode creuse, le débit de précurseur gazeux d'un dérivé organique de silane, tel que TMDSO, est inférieur à 200 sccm par mètre linéaire de source plasma, préférentiellement compris entre 50 et 150 sccm par mètre linéaire de source plasma, la vitesse de dépôt étant inférieure à 200 nm.m/min, de préférence inférieure à 150 nm.m/min, en particulier inférieure à 100 nm.m/min, la pression étant inférieure à 15 mTorr. On utilise comme précurseur gazeux un dérivé organique de silane, tel que TMDSO, et l'oxygène pur comme gaz réactif, le rapport entre le débit d'oxygène et le débit du précurseur gazeux étant supérieur à 5, voire supérieur à 15. La source définie à l'étape a) du dispositif PECVD est placée avant le système de revêtement de couches ultérieures, lesquelles peuvent être déposées par pulvérisation magnétron ou par CVD. Ceci garantit un taux de carbone dans la couche de SiO₂ inférieur à 2%, voire inférieur à 0,5% ou à 0,1%.

Les valeurs ci-dessus de taux de carbone peuvent également être obtenues par l'ajout d'un gaz inerte de sorte que le rapport gaz réactif/gaz inerte est d'au moins 5, avantageusement compris entre 5 et 30, en particulier valant 20. Le gaz inerte est, de préférence, He, Ne, Kr et Ar.

En variante, les valeurs citées plus haut de taux de carbone peuvent être obtenues en modifiant le voltage de la cathode ce qui peut être effectué par changement du matériau constitutif de l'électrode ou en adaptant les modules du générateur de puissance ou en modifiant la pression. On passe habituellement d'une tension d'environ 400 V à environ 340 V, voire 300 V. En variante encore, les valeurs désirées peuvent être obtenues en opérant dans une gamme de pressions comprises entre 5 et 20 mTorr, de préférence entre 5 et 10 mTorr, les valeurs de 9-10 mTorr étant celles qui donnent les meilleurs résultats.

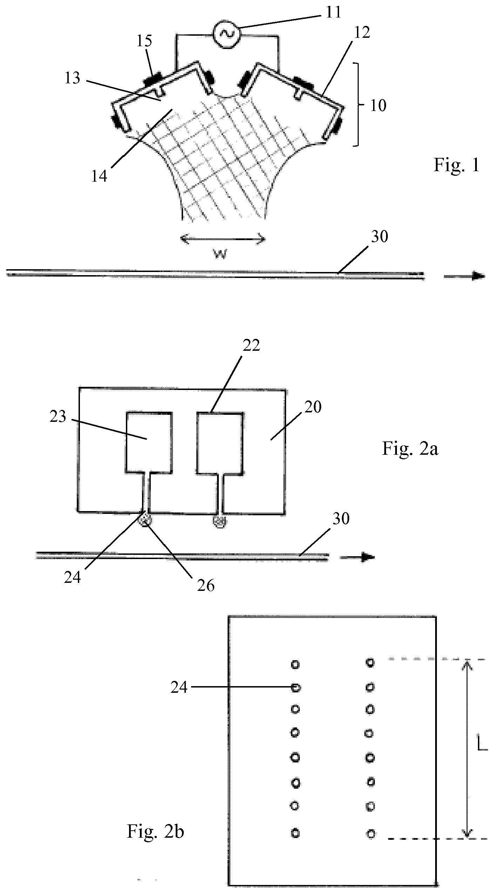

Des dispositifs PECVD pouvant être utilisés dans des procédés selon l'invention vont à présent être décrits, en tant qu'exemples, tout en faisant référence aux Figures 1 et 2. Les différents éléments des figures ne sont pas représentés à l'échelle.
Figure 1: coupe transversale d'un dispositif de PECVD comprenant une source à doubles faisceaux linéaires de plasma.
Figure 2a: coupe transversale d'un dispositif de PECVD comprenant une source de plasma à cathode creuse.
Figure 2b: vue de la face inférieure (faisant face au substrat) d'une source de plasma à cathode creuse.

A la figure 1, la source PECVD représentée est une source à doubles faisceaux linéaires de plasma (10), comprenant deux cavités (13) dans lesquelles a lieu la décharge et d'ouvertures (14) d'où elle est expulsée. Chaque cavité inclut une électrode (12) connectée à un générateur de puissance (11) qui débite soit du courant alternatif (AC) soit du DC pulsé. Dans la source de plasma se trouve une série d'aimants (15) qui se font face et qui bordent la cavité. Le gaz injecté dans chaque cavité est ainsi ionisé et forme un faisceau d'ions, il forme ce que l'on appelle une source de plasma (16) qui est émis hors de la source par une ouverture (14) en direction du substrat à revêtir (30). La flèche indique le sens de défilement du substrat lors du dépôt. La largeur totale du plasma est représentée par "w", sa longueur totale est, elle, mesurée perpendiculairement, c'est-à-dire dans la direction de la largeur du substrat à revêtir.

A la figure 2, la source PECVD représentée est une source de plasma à cathode creuse (20) comprenant deux cavités (23) formant deux électrodes (22) reliées à un générateur AC ou DC pulsé (non représenté), dans lesquelles a lieu la décharge et d'ouvertures (24) d'où le plasma (26) est expulsé en direction du substrat à revêtir (30). La flèche indique le sens de défilement du substrat lors du dépôt. La distance entre les extrémités du plasma dans la direction de la largeur du substrat à recouvrir est représentée par "L". Dans cette figure, les ouvertures se présentent en deux rangées de trous de sortie, mais d'autres configurations sont possibles: par exemple, une seule rangée de trous ou plus de deux rangées de trous, une ou plusieurs fentes longitudinales.

L'invention concerne également des films d'oxydes, de nitrures ou d'oxynitrures de métaux ou semi-conducteurs choisis dans le groupe constitué par SiO₂, TiO₂, SnO₂, ZrO₂, Al₂O₃, AIN, TiN, ZnO, nitrure de silicium, TaN, WO₃, CrOₓ et CrN, lesdits composants pouvant être dopés, ainsi que les alliages de ces composants, contenant au plus 2% atomique de résidus provenant du précurseur, notamment choisis dans le groupe constitué par H, C, Cl, dérivés de CHₓ, dérivés de NHₓ et dérivés de OHₓ, x étant compris entre 1 et 4, obtenus par la mise en oeuvre du procédé.

En effet, le Demandeur a montré que des tels films sont très avantageusement utilisés pour la production de couches ou d'empilages de couches sur des substrats, en particulier de verre. Grâce à cette faible teneur en composés constitués des résidus provenant des précurseurs, les couches de ces oxydes, nitrures ou oxynitrures, lorsque déposées sur un substrat verrier, permettent de conserver voire d'optimiser les propriétés optiques, électriques et structurelles, telles que de barrière de migration des ions sodium, de contrôle du "haze", anti-rayures, anti-réfléchissantes, permettant de "rafraîchir" les surfaces de substrats verriers, et/ou d'assurer une trempe homogène et sans défauts du film ainsi déposé.

## Revendications

1. Procédé de production de films d'oxydes, de nitrures ou d'oxynitrures de métaux ou semi-conducteurs sur un substrat, par la méthode de PECVD comprenant les étapes consistant à :
a) se munir d'un dispositif de PECVD, à basse pression, comprenant au moins une source à doubles faisceaux linéaires de plasma, laquelle comprend au moins deux électrodes reliées à un générateur AC ou DC pulsé, pour le dépôt desdits films sur le substrat,
b) appliquer une puissance électrique entre les deux électrodes de façon telle que la densité de puissance du plasma soit comprise entre 5 et 50 W par cm² de plasma, et,
c) appliquer sur le substrat un précurseur gazeux de films d'oxydes, de nitrures ou d'oxynitrures de métaux ou semi-conducteurs à un débit compris entre 100 et 500 sccm par mètre linéaire de la source de plasma, et un gaz réactif à base d'oxygène ou de dérivés oxygénés ou de dérivés azotés à un débit compris entre 500 et 20000 sccm par mètre linéaire de la source de plasma.

2. Procédé de production de films d'oxydes, de nitrures ou d'oxynitrures de métaux ou semi-conducteurs sur un substrat, par la méthode de PECVD comprenant les étapes consistant à :
a) se munir d'un dispositif de PECVD, à basse pression, comprenant au moins une source de plasma à cathode creuse, laquelle comprend au moins une électrode reliée à un générateur AC, DC ou DC pulsé, pour le dépôt desdits films sur le substrat,
b) appliquer une puissance électrique à la source de plasma de façon telle que la densité de puissance du plasma soit comprise entre 15 et 100 kW par mètre de plasma, et,
c) appliquer sur le substrat un précurseur gazeux de films d'oxydes, de nitrures ou d'oxynitrures de métaux ou semi-conducteurs à un débit compris entre 100 et 500 sccm par mètre linéaire de la source de plasma, et un gaz réactif à base d'oxygène ou de dérivés oxygénés ou de dérivés azotés à un débit compris entre 500 et 20000 sccm par mètre linéaire de la source de plasma.

3. Procédé selon la revendication 1, dans lequel, à l'étape a), la source du dispositif PECVD présente des dimensions comprises entre de 250 mm et 4000 mm de longueur et entre 100 et 800 mm de largeur, fournissant une puissance comprise entre 5 kW et 50 kW par mètre linéaire de la source de plasma.

4. Procédé selon l'une des revendications 1 à 3, dans lequel, à l'étape a), la pression est comprise entre 0,001 et 0,5 Torr.

5. Procédé selon l'une des revendications 1 à 4, dans lequel, à l'étape a), les fréquences du générateur AC ou DC pulsé sont comprises entre 5 et 150 kHz.

6. Procédé selon l'une des revendications 1 à 5, dans lequel le rapport molaire de gaz réactif/précurseur gazeux est, pour les films de type M^{(x)}O_{x/2}, supérieur ou égal à (x/2 - y)/z, x étant la valence de l'oxyde métallique à obtenir, y étant le nombre d'atomes d'oxygène présent dans le précurseur de départ et z étant le nombre d'atomes d'oxygène présent dans le gaz réactif.

7. Procédé selon l'une des revendications 1 à 5, dans lequel le rapport molaire de gaz réactif/précurseur gazeux, pour les films de type M^{(x)}N_{x/3}, est supérieur ou égal à (x/3 - y)/z, x étant la valence du nitrure métallique à obtenir, y étant le nombre d'atomes d'azote présent dans le précurseur de départ et z étant le nombre d'atomes d'azote présent dans le gaz réactif.

8. Procédé selon l'une des revendications 1 à 7, dans lequel le rapport entre le débit du gaz réactif et le débit du précurseur gazeux est d'au moins 5, avantageusement compris entre 5 et 30.

9. Procédé selon l'une des revendications 1 à 8, dans lequel le débit du précurseur gazeux de films d'oxydes, de nitrures ou d'oxynitrures de métaux ou semi-conducteurs est compris entre 150 et 500 sccm par mètre linéaire de source plasma.

10. Procédé selon l'une des revendications 1 à 9, dans lequel la vitesse de dépôt est de 100 à 400 nm.m/min.

11. Procédé pour la production d'un substrat verrier sur lequel est déposée en contact direct avec le substrat une couche de SiO₂, par la méthode de PECVD comprenant les étapes consistant à :
a) se munir d'un dispositif de PECVD, à basse pression, comprenant au moins:
a.i) soit une source à doubles faisceaux linéaires de plasma, laquelle comprend au moins deux électrodes reliées à un générateur AC ou DC pulsé,
a.ii) soit une source de plasma à cathode creuse, laquelle comprend au moins une électrode reliée à un générateur AC, DC ou DC pulsé,
b) appliquer une puissance électrique
b.i) soit, dans le cas d'une source à double faisceaux linéaires de plasma, entre les deux électrodes de façon telle que la densité de puissance du plasma soit supérieure à 5 W par cm² de plasma et inférieure ou égale à 50 W par cm² de plasma,
b.ii) soit, dans le cas d'une source de plasma à cathode creuse, à la source de plasma de façon telle que la densité de puissance du plasma soit supérieure à 15 kW par mètre de plasma et inférieure ou égale à 100 kW par mètre de plasma,
c) et, appliquer sur le substrat un précurseur gazeux d'un dérivé organique de silane et de l'oxygène pur comme gaz réactif à un débit compris entre 500 et 20000 sccm par mètre linéaire de la source de plasma,
**caractérisé en ce que**:
(i) le débit de du précurseur gazeux d'un dérivé organique de silane est compris entre 100 et 500 sccm par mètre linéaire de la source plasma
(ii) la vitesse de dépôt est inférieure à 400 nm.m/min,
(iii) la pression du dispositif PECVD est comprise entre 3 et 20 mTorr,
(iv) le rapport entre le débit d'oxygène et le débit du dérivé organique de silane est supérieur à 5.

12. Procédé pour la production de couches de SiO₂ déposées soit directement sur un substrat verrier, soit dans un empilage avec d'autres couches en position quelconque, ou bien en tant que couche la plus extérieure d'un empilage pour le contrôle des valeurs de "haze" dans des empilages destinés aux applications solaires incorporant des couches Low-E, lesdites valeurs de "haze" étant d'au moins 5%, par la méthode de PECVD comprenant les étapes consistant à :
a) se munir d'un dispositif de PECVD, à basse pression, comprenant au moins:
a.i) soit une source à doubles faisceaux linéaires de plasma, laquelle comprend au moins deux électrodes reliées à un générateur AC ou DC pulsé,
a.ii) soit une source de plasma à cathode creuse, laquelle comprend au moins une électrode reliée à un générateur AC, DC ou DC pulsé,
b) appliquer une puissance électrique
b.i) soit, dans le cas d'une source à double faisceaux linéaires de plasma, entre les deux électrodes,
b.ii) soit, dans le cas d'une source de plasma à cathode creuse, à la source de plasma,
c) et, appliquer sur le substrat un précurseur gazeux d'un dérivé organique de silane et un gaz réactif à base d'oxygène ou de dérivés oxygénés à un débit compris entre 500 et 20000 sccm par mètre linéaire de la source de plasma,
**caractérisé en ce que**:
(i) la puissance appliquée à l'étape b) est telle que la densité de puissance du plasma est comprise entre 5 et 10 W par cm² de plasma pour une source à double faisceaux linéaires de plasma ou comprise entre 15 et 20 kW par mètre de plasma pour une source de plasma à cathode creuse,
(ii) le débit du précurseur gazeux d'un dérivé organique de silane est supérieur ou égal à 100 sccm par mètre linéaire de plasma et inférieur à 400 sccm par mètre linéaire de source plasma,
(iii) le rapport entre le débit d'oxygène et le débit du précurseur gazeux est supérieur à 5, et
(iv) la vitesse de dépôt est inférieure à 400 nm.m/min.

13. Procédé pour la production de couches de SiO₂ déposées soit directement sur un substrat verrier, soit dans un empilage avec d'autres couches en position quelconque, ou bien en tant que couche la plus extérieure d'un empilage pour le contrôle des valeurs de "haze" dans des empilages destinés aux applications solaires incorporant des couches Low-E, lesdites valeurs de "haze" étant inférieure à 0,5%, par la méthode de PECVD comprenant les étapes consistant à :
a) se munir d'un dispositif de PECVD, à basse pression, comprenant au moins:
a.i) soit une source à doubles faisceaux linéaires de plasma, laquelle comprend au moins deux électrodes reliées à un générateur AC ou DC pulsé,
a.ii) soit une source de plasma à cathode creuse, laquelle comprend au moins une électrode reliée à un générateur AC, DC ou DC pulsé,
b) appliquer une puissance électrique
b.i) soit, dans le cas d'une source à double faisceaux linéaires de plasma, entre les deux électrodes de façon telle que la densité de puissance du plasma soit comprise entre 5 et 50 W par cm² de plasma,
b.ii) soit, dans le cas d'une source de plasma à cathode creuse, à la source de plasma de façon telle que la densité de puissance du plasma soit comprise entre 15 et 100 kW par mètre de plasma,
c) et, appliquer sur le substrat un précurseur gazeux d'un dérivé organique de silane et un gaz réactif à base d'oxygène ou de dérivés oxygénés à un débit compris entre 500 et 20000 sccm par mètre linéaire de la source de plasma,
**caractérisé en ce que**:
(i) la pression est supérieure à 5 mTorr,
(ii) le débit du précurseur gazeux d'un dérivé organique de silane est supérieure ou égale à 100 sccm par mètre linéaire de source plasma et inférieure à 400 sccm par mètre linéaire de source plasma,
(iii) le rapport entre le débit d'oxygène et le débit du précurseur gazeux est supérieur à 15, et
(iv) la vitesse de dépôt est inférieure à 400 nm.m/min.

14. Procédé pour la production de couches choisies dans le groupe constitué par SiO₂, ZrO₂ et Al₂O₃, déposées soit directement sur un substrat verrier, soit en tant que couche la plus extérieure d'un empilage dans le but de conférer des propriétés anti-rayures au substrat revêtu ou non, par la méthode de PECVD comprenant les étapes consistant à :
a) se munir d'un dispositif de PECVD, à basse pression, comprenant au moins:
a.i) soit une source à doubles faisceaux linéaires de plasma, laquelle comprend au moins deux électrodes reliées à un générateur AC ou DC pulsé,
a.ii) soit une source de plasma à cathode creuse, laquelle comprend au moins une électrode reliée à un générateur AC, DC ou DC pulsé,
b) appliquer une puissance électrique
b.i) soit, dans le cas d'une source à double faisceaux linéaires de plasma, entre les deux électrodes de façon telle que la densité de puissance du plasma soit comprise entre 10 et 40 W par cm² de plasma,
b.ii) soit, dans le cas d'une source de plasma à cathode creuse, à la source de plasma de façon telle que la densité de puissance du plasma soit entre 20 et 50 kW par mètre de plasma,
c) et, appliquer sur le substrat un précurseur gazeux de films d'oxydes de métaux ou semi-conducteurs et un gaz réactif à base d'oxygène ou de dérivés oxygénés à un débit compris entre 500 et 20000 sccm par mètre linéaire de la source de plasma,
**caractérisé en ce que**:
(i) la pression est inférieure à 10 mTorr,
(ii) le débit du précurseur gazeux de films d'oxydes de métaux ou semi-conducteurs est compris entre 150 et 500 sccm par mètre linéaire de source plasma,
(iii) le rapport entre le débit d'oxygène et le débit du précurseur gazeux est supérieur à 10, et
(iv) la vitesse de dépôt est inférieure à 400 nm.m/min.

15. Procédé pour la production d'empilages sur un substrat verrier présentant des propriétés anti-réfléchissantes (AR), ledit empilage comprenant une succession de couches de hauts indices de réfraction et à bas indices de réfraction, par la méthode de PECVD comprenant les étapes consistant à :
a) se munir d'un dispositif de PECVD, à basse pression, comprenant au moins:
a.i) soit une source à doubles faisceaux linéaires de plasma, laquelle comprend au moins deux électrodes reliées à un générateur AC ou DC pulsé,
a.ii) soit une source de plasma à cathode creuse, laquelle comprend au moins une électrode reliée à un générateur AC, DC ou DC pulsé,
b) appliquer une puissance électrique
b.i) soit, dans le cas d'une source à double faisceaux linéaires de plasma, entre les deux électrodes de façon telle que la densité de puissance du plasma soit comprise entre 10 et 40 W par cm² de plasma,
b.ii) soit, dans le cas d'une source de plasma à cathode creuse, à la source de plasma de façon telle que la densité de puissance du plasma soit entre 20 et 50 kW par mètre de plasma,
c) et, appliquer sur le substrat un précurseur gazeux d'un dérivé organique de silane et un gaz réactif à base d'oxygène ou de dérivés oxygénés à un débit compris entre 500 et 20000 sccm par mètre linéaire de la source de plasma,
**caractérisé en ce que**:
(i) la pression est inférieure à 20 mTorr,
(ii) le débit du précurseur gazeux d'un dérivé organique de silane est supérieur ou égal à 100 sccm par mètre linéaire de plasma et inférieur à 400 sccm par mètre linéaire de source plasma,
(iii) le rapport entre le débit d'oxygène et le débit du précurseur gazeux est supérieur à 5, et
(iv) la vitesse de dépôt est inférieure à 400 nm.m/min.

16. Procédé pour la production d'une couche de SiO₂ transparente déposée sur un substrat en verre revêtu d'une couche Low-E, par la méthode de PECVD comprenant les étapes consistant à :
a) se munir d'un dispositif de PECVD, à basse pression, comprenant au moins:
a.i) soit une source à doubles faisceaux linéaires de plasma, laquelle comprend au moins deux électrodes reliées à un générateur AC ou DC pulsé,
a.ii) soit une source de plasma à cathode creuse, laquelle comprend au moins une électrode reliée à un générateur AC, DC ou DC pulsé,
b) appliquer une puissance électrique
b.i) soit, dans le cas d'une source à double faisceaux linéaires de plasma, entre les deux électrodes de façon telle que la densité de puissance du plasma soit supérieure à 5 W par cm² de plasma et inférieure ou égale à 50 W par cm² de plasma,
b.ii) soit, dans le cas d'une source de plasma à cathode creuse, à la source de plasma de façon telle que la densité de puissance du plasma soit supérieure à 15 kW par mètre de plasma et inférieure ou égale à 100 kW par mètre de plasma,
c) et, appliquer sur le substrat un précurseur gazeux d'un dérivé organique de silane et un gaz réactif à base d'oxygène ou de dérivés oxygénés à un débit compris entre 500 et 20000 sccm par mètre linéaire de la source de plasma,
**caractérisé en ce que**:
(i) la pression est inférieure à 20 mTorr,
(ii) le débit du précurseur gazeux d'un dérivé organique de silane est supérieur ou égal à 100 sccm par mètre linéaire de plasma et inférieur à 400 sccm par mètre linéaire de source plasma,
(iii) le rapport entre le débit d'oxygène et le débit du précurseur gazeux est supérieur à 5, et
(iv) la vitesse de dépôt est inférieure à 200 nm.m/min.

17. Procédé pour rafraîchir la surface du verre,
a) se munir d'un dispositif de PECVD, à basse pression, comprenant au moins:
a.i) soit une source à doubles faisceaux linéaires de plasma, laquelle comprend au moins deux électrodes reliées à un générateur AC ou DC pulsé,
a.ii) soit une source de plasma à cathode creuse, laquelle comprend au moins une électrode reliée à un générateur AC, DC ou DC pulsé,
b) appliquer une puissance électrique
b.i) soit, dans le cas d'une source à double faisceaux linéaires de plasma, entre les deux électrodes de façon telle que la densité de puissance du plasma soit supérieure à 5 W par cm² de plasma et inférieure ou égale à 50 W par cm² de plasma,
b.ii) soit, dans le cas d'une source de plasma à cathode creuse, à la source de plasma de façon telle que la densité de puissance du plasma soit supérieure à 15 kW par mètre de plasma et inférieure ou égale à 100 kW par mètre de plasma,
c) et, appliquer sur le substrat un précurseur gazeux d'un dérivé organique de silane et un gaz réactif à base d'oxygène ou de dérivés oxygénés à un débit compris entre 500 et 20000 sccm par mètre linéaire de la source de plasma,
**caractérisé en ce que**:
(i) le débit du précurseur gazeux d'un dérivé organique de silane est supérieur ou égal à 100 sccm par mètre linéaire de plasma et inférieur à 200 sccm par mètre linéaire de source plasma,
(ii) la vitesse de dépôt est inférieure à 200 nm.m/min,
(iii) la pression est inférieure à 15 mTorr, et
(iv) le rapport entre le débit d'oxygène et le débit du précurseur gazeux est supérieur à 5.

## Patentansprüche

1. Herstellungsverfahren für Metalloxid-, Metallnitrid- oder Metalloxinitrid- oder Halbleiterschichten auf einem Substrat durch das PECVD-Verfahren, umfassend die Schritte bestehend aus:
a) Bereitstellen einer PECVD-Vorrichtung mit Niederdruck, umfassend mindestens eine Plasmaquelle mit linearem Doppelstrahl, die mindestens zwei mit einem Pulswechselstrom- oder Pulsgleichstromgenerator verbundene Elektroden umfasst, für die Abscheidung der Schichten auf dem Substrat,
b) Anlegen einer elektrischen Leistung zwischen die beiden Elektroden derart, dass die Leistungsdichte des Plasmas zwischen 5 und 50 W pro cm² Plasma liegt, und
c) Aufbringen eines gasförmigen Vorläufers von Metalloxid-, Metallnitrid- oder Metalloxinitrid- oder Halbleiterschichten auf dem Substrat mit einem Volumenstrom zwischen 100 und 500 sccm pro linearem Meter der Plasmaquelle und eines Reaktivgases auf der Basis von Sauerstoff oder sauerhaltigen Derivaten oder stickstoffhaltigen Derivaten mit einem Volumenstrom zwischen 500 und 20.000 sccm pro linearem Meter der Plasmaquelle.

2. Herstellungsverfahren für Metalloxid-, Metallnitrid- oder Metalloxinitrid- oder Halbleiterschichten auf einem Substrat durch das PECVD-Verfahren, umfassend die Schritte bestehend aus:
a) Bereitstellen einer PECVD-Vorrichtung mit Niederdruck, umfassend mindestens eine Plasmaquelle mit Hohlkatode, die mindestens eine mit einem Wechselstrom-, Gleichstrom- oder Pulsgleichstromgenerator verbundene Elektrode umfasst, für die Abscheidung der Schichten auf dem Substrat,
b) Anlegen einer elektrischen Leistung an die Plasmaquelle derart, dass die Leistungsdichte des Plasmas zwischen 15 und 100 kW pro Meter Plasma liegt, und
c) Aufbringen eines gasförmigen Vorläufers von Metalloxid-, Metallnitrid- oder Metalloxinitrid- oder Halbleiterschichten auf dem Substrat mit einem Volumenstrom zwischen 100 und 500 sccm pro linearem Meter der Plasmaquelle und eines Reaktivgases auf der Basis von Sauerstoff oder sauerstoffhaltigen Derivaten oder stickstoffhaltigen Derivaten mit einem Volumenstrom zwischen 500 und 20.000 sccm pro linearem Meter der Plasmaquelle.

3. Verfahren nach Anspruch 1, bei dem in Schritt a) die Quelle der PECVD-Vorrichtung Abmessungen zwischen 250 mm und 4000 mm Länge und zwischen 100 und 800 mm Breite aufweist und eine Leistung zwischen 5 kW und 50 kW pro linearem Meter der Plasmaquelle bereitstellt.

4. Verfahren nach einem der Ansprüche 1 bis 3, bei dem in Schritt a) der Druck zwischen 0,001 und 0,5 Torr liegt.

5. Verfahren nach einem der Ansprüche 1 bis 4, bei dem in Schritt a) die Frequenzen des Pulswechselstrom- oder Pulsgleichstromgenerators zwischen 5 und 150 kHz liegen.

6. Verfahren nach einem der Ansprüche 1 bis 5, bei dem das Molverhältnis von Reaktivgas/Vorläufergas bei den Schichten des Typs M^{(x)}O_{x/2} größer oder gleich (x/2 - y)/z ist, wobei x die Wertigkeit des zu erhaltenden Metalloxids ist, y die Anzahl der Sauerstoffatome, die im Ausgangsvorläufer vorhanden sind, und z die Anzahl der Sauerstoffatome ist, die im Reaktivgas vorhanden sind.

7. Verfahren nach einem der Ansprüche 1 bis 5, bei dem das Molverhältnis von Reaktivgas/Vorläufergas bei den Schichten des Typs M^{(x)}N_{x/3} größer oder gleich (x/3 - y)/z ist, wobei x die Wertigkeit des zu erhaltenden Metallnitrids ist, y die Anzahl der Stickstoffatome, die im Ausgangsvorläufer vorhanden sind, und z die Anzahl der Stickstoffatome ist, die im Reaktivgas vorhanden sind.

8. Verfahren nach einem der Ansprüche 1 bis 7, bei dem das Verhältnis zwischen dem Volumenstrom des Reaktivgases und dem Volumenstrom des gasförmigen Vorläufers mindestens 5 beträgt, vorzugsweise zwischen 5 und 30.

9. Verfahren nach einem der Ansprüche 1 bis 8, bei dem der Volumenstrom des gasförmigen Vorläufers von Metalloxid-, Metallnitrid- oder Metalloxinitrid- oder Halbleiterschichten zwischen 150 und 500 sccm pro linearem Meter der Plasmaquelle liegt.

10. Verfahren nach einem der Ansprüche 1 bis 9, bei dem die Abscheidungsrate von 100 bis 400 nm.m/min beträgt.

11. Verfahren zur Herstellung eines Glassubstrats, auf dem in direktem Kontakt mit dem Substrat eine Schicht SiO₂ mittels des PECVD-Verfahrens abgeschieden wird, umfassend die Schritte bestehend aus:
a) Bereitstellen einer PECVD-Vorrichtung mit Niederdruck, umfassend mindestens:
a.i) entweder eine Plasmaquelle mit linearem Doppelstrahl, die mindestens zwei mit einem Pulswechselstrom- oder Pulsgleichstromgenerator verbundene Elektroden umfasst,
a.ii) oder eine Plasmaquelle mit Hohlkatode, die mindestens eine mit einem Wechselstrom-, Gleichstrom- oder Pulsgleichstromgenerator verbundene Elektrode umfasst,
b) Anlegen einer elektrischen Leistung
b.i) entweder im Fall einer Plasmaquelle mit linearem Doppelstrahl zwischen die beiden Elektroden derart, dass die Leistungsdichte des Plasma größer ist als 5 W pro cm² Plasma ist und kleiner oder gleich 50 W pro cm² Plasma ist,
b.ii) oder im Fall einer Quelle mit Hohlkatode an die Plasmaquelle derart, dass die Leistungsdichte des Plasmas größer als 15 kW pro Meter Plasma und kleiner oder gleich 100 kW pro Meter Plasma ist,
c) und Aufbringen eines gasförmigen Vorläufers eines organischen Silanderivats und reinen Sauerstoffs als Reaktivgas mit einem Volumenstrom zwischen 500 und 20.000 sccm pro linearem Meter der Plasmaquelle,
**dadurch gekennzeichnet, dass**:
(i) der Volumenstrom des gasförmigen Vorläufers eines organischen Silanderivats zwischen 100 und 500 sccm pro linearem Meter der Plasmaquelle liegt,
(ii) die Abscheidungsrate kleiner als 400 nm.m/min ist,
(iii) der Druck der PECVD-Vorrichtung zwischen 3 und 20 mTorr liegt,
(iv) das Verhältnis zwischen dem Volumenstrom des Sauerstoffs und dem Volumenstrom des organischen Silanderivats größer als 5 ist.

12. Verfahren zur Herstellung von SiO₂-Schichten, abgeschieden entweder direkt auf einem Glassubstrat, in einem Stapel mit anderen Schichten in jeglicher Position oder als äußerste Schicht eines Stapels zur Steuerung der "Haze"-Werte in Stapeln, die für Low-E-Schichten enthaltende Solaranwendungen bestimmt sind, wobei die "Haze"-Werte mindestens 5 % betragen, mittels des PECVD-Verfahrens, umfassend die Schritte bestehend aus:
a) Bereitstellen einer PECVD-Vorrichtung mit Niederdruck, umfassend mindestens:
a.i) entweder eine Plasmaquelle mit linearem Doppelstrahl, die mindestens zwei mit einem Pulswechselstrom- oder Pulsgleichstromgenerator verbundene Elektroden umfasst,
a.ii) oder eine Plasmaquelle mit Hohlkatode, die mindestens eine mit einem Wechselstrom-, Gleichstrom- oder Pulsgleichstromgenerator verbundene Elektrode umfasst,
b) Anlegen einer elektrischen Leistung
b.i) entweder im Fall einer Plasmaquelle mit linearem Doppelstrahl zwischen die beiden Elektroden
b.ii) oder im Fall einer Plasmaquelle mit Hohlkatode an die Plasmaquelle,
c) und Aufbringen eines gasförmigen Vorläufers eines organischen Silanderivats und eines Reaktivgases auf der Basis von Sauerstoff oder sauerhaltigen Derivaten auf das Substrat mit einem Volumenstrom zwischen 500 und 20.000 sccm pro linearem Meter der Plasmaquelle,
**dadurch gekennzeichnet, dass**:
(i) die angelegte Leistung im Schritt b) derart ist, dass die Leistungsdichte des Plasmas bei der Plasmaquelle mit linearem Doppelstrahl zwischen 5 und 10 W pro cm² Plasma oder bei einer Plasmaquelle mit Hohlkatode zwischen 15 und 20 kW pro Meter Plasma liegt,
(ii) der Volumenstrom des gasförmigen Vorläufers eines organischen Silanderivats größer oder gleich 100 sccm pro linearem Meter Plasma und kleiner als 400 sccm pro linearem Meter der Plasmaquelle ist,
(iii) das Verhältnis zwischen dem Volumenstrom des Sauerstoffs und dem Volumenstrom des gasförmigen Vorläufers größer als 5 ist und
(iv) die Abscheidungsgeschwindigkeit kleiner als 400 nm.m/min ist.

13. Verfahren zur Herstellung von SiO₂₋Schichten, abgeschieden entweder direkt auf einem Glassubstrat, in einem Stapel mit anderen Schichten in jeglicher Position oder als äußerste Schicht eines Stapels zur Steuerung der "Haze"-Werte in Stapeln, die für Low-E-Schichten enthaltende Solaranwendungen bestimmt sind, wobei die "Haze"-Werte kleiner als 0,5 % sind, mittels des PECVD-Verfahrens, umfassend die Schritte bestehend aus:
a) Bereitstellen einer PECVD-Vorrichtung mit Niederdruck, umfassend mindestens:
a.i) entweder eine Plasmaquelle mit linearem Doppelstrahl, die mindestens zwei mit einem Pulswechselstrom- oder Pulsgleichstromgenerator verbundene Elektroden umfasst,
a.ii) oder eine Plasmaquelle mit Hohlkatode, die mindestens eine mit einem Wechselstrom-, Gleichstrom- oder Pulsgleichstromgenerator verbundene Elektrode umfasst,
b) Anlegen einer elektrischen Leistung
b.i) entweder im Fall einer Plasmaquelle mit linearem Doppelstrahl zwischen die beiden Elektroden derart, dass die Leistungsdichte des Plasmas zwischen 5 und 50 W pro cm² Plasma liegt,
b.ii) oder im Fall einer Plasmaquelle mit Hohlkatode an die Plasmaquelle derart, dass die Leistungsdichte des Plasmas zwischen 15 und 100 kW pro Meter Plasma liegt,
c) und Aufbringen eines gasförmigen Vorläufers eines organischen Silanderivats und eines Reaktivgases auf der Basis von Sauerstoff oder sauerstoffhaltigen Derivaten auf das Substrat mit einem Volumenstrom zwischen 500 und 20.000 sccm pro linearem Meter der Plasmaquelle,
**dadurch gekennzeichnet, dass**:
(i) der Druck größer als 5 mTorr ist,
(ii) der Volumenstrom des gasförmigen Vorläufers eines organischen Silanderivats größer oder gleich 100 sccm pro linearem Meter Plasma und kleiner als 400 sccm pro linearem Meter der Plasmaquelle ist,
(iii) das Verhältnis zwischen dem Volumenstrom des Sauerstoffs und dem Volumenstrom des gasförmigen Vorläufers größer als 15 ist und
(iv) die Abscheidungsgeschwindigkeit kleiner als 400 nm.m/min ist.

14. Verfahren zur Herstellung von Schichten, ausgewählt aus der Gruppe SiO₂, ZrO₂ und Al₂O₃, abgeschieden entweder direkt auf einem Glassubstrat oder als äußerste Schicht eines Stapels mit dem Ziel, dem beschichteten oder nicht beschichteten Substrat Kratzfestigkeitseigenschaften zu verleihen, mittels des PECVD-Verfahrens, umfassend die Schritte bestehend aus:
a) Bereitstellen einer PECVD-Vorrichtung mit Niederdruck, umfassend mindestens:
a.i) entweder eine Plasmaquelle mit linearem Doppelstrahl, die mindestens zwei mit einem Pulswechselstrom- oder Pulsgleichstromgenerator verbundene Elektroden umfasst,
a.ii) oder eine Plasmaquelle mit Hohlkatode, die mindestens eine mit einem Wechselstrom-, Gleichstrom- oder Pulsgleichstromgenerator verbundene Elektrode umfasst,
b) Anlegen einer elektrischen Leistung
b.i) entweder im Fall einer Plasmaquelle mit linearem Doppelstrahl zwischen die beiden Elektroden derart, dass die Leistungsdichte des Plasmas zwischen 10 und 40 W pro cm² Plasma liegt,
b.ii) oder im Fall einer Plasmaquelle mit Hohlkatode an die Plasmaquelle derart, dass die Leistungsdichte des Plasmas zwischen 20 und 50 kW pro Meter Plasma liegt,
c) und Aufbringen eines gasförmigen Vorläufers von Metalloxid- oder Halbleiterschichten und eines Reaktivgases auf der Basis von Sauerstoff oder sauerhaltigen Derivaten auf das Substrat mit einem Volumenstrom zwischen 500 und 20.000 sccm pro linearem Meter der Plasmaquelle,
**dadurch gekennzeichnet, dass**:
(i) der Druck kleiner als 10 mTorr ist,
(ii) der Volumenstrom des gasförmigen Vorläufers von Metalloxid- oder Halbleiterschichten zwischen 150 und 500 sccm pro linearem Meter der Plasmaquelle ist,
(iii) das Verhältnis zwischen dem Volumenstrom des Sauerstoffs und dem Volumenstrom des gasförmigen Vorläufers größer als 10 ist und
(iv) die Abscheidungsgeschwindigkeit kleiner als 400 nm.m/min ist.

15. Verfahren zur Herstellung von Stapeln auf einem Glassubstrat, die Antireflexionseigenschaften (AR) aufweisen, wobei der Stapel eine Abfolge von Schichten mit hohem Brechungsindex und niedrigem Brechungsindex umfasst, mittels des PECVD-Verfahrens, umfassend die Schritte bestehend aus:
a) Bereitstellen einer PECVD-Vorrichtung mit Niederdruck, umfassend mindestens:
a.i) entweder eine Plasmaquelle mit linearem Doppelstrahl, die mindestens zwei mit einem Pulswechselstrom- oder Pulsgleichstromgenerator verbundene Elektroden umfasst,
a.ii) oder eine Plasmaquelle mit Hohlkatode, die mindestens eine mit einem Wechselstrom-, Gleichstrom- oder Pulsgleichstromgenerator verbundene Elektrode umfasst,
b) Anlegen einer elektrischen Leistung
b.i) entweder im Fall einer Plasmaquelle mit linearem Doppelstrahl zwischen die beiden Elektroden derart, dass die Leistungsdichte des Plasmas zwischen 10 und 40 W pro cm² Plasma liegt,
b.ii) oder im Fall einer Plasmaquelle mit Hohlkatode an die Plasmaquelle derart, dass die Leistungsdichte des Plasmas zwischen 20 und 50 kW pro Meter Plasma liegt,
c) und Aufbringen eines gasförmigen Vorläufers eines organischen Silanderivats und eines Reaktivgases auf der Basis von Sauerstoff oder sauerhaltigen Derivaten auf das Substrat mit einem Volumenstrom zwischen 500 und 20.000 sccm pro linearem Meter der Plasmaquelle,
**dadurch gekennzeichnet, dass**:
(i) der Druck kleiner als 20 mTorr ist,
(ii) der Volumenstrom des gasförmigen Vorläufers eines organischen Silanderivats größer oder gleich 100 sccm pro linearem Meter der Plasmaquelle und kleiner als 400 sccm pro linearem Meter der Plasmaquelle ist,
(iii) das Verhältnis zwischen dem Volumenstrom des Sauerstoffs und dem Volumenstrom des gasförmigen Vorläufers größer als 5 ist und
(iv) die Abscheidungsgeschwindigkeit kleiner als 400 nm.m/min ist.

16. Verfahren zur Herstellung einer transparenten SiO₂-Schicht, abgeschieden auf einem mit einer Low-E-Schicht beschichteten Glassubstrat mittels des PECVD-Verfahrens, umfassend die Schritte bestehend aus:
a) Bereitstellen einer PECVD-Vorrichtung mit Niederdruck, umfassend mindestens:
a.i) entweder eine Plasmaquelle mit linearem Doppelstrahl, die mindestens zwei mit einem Pulswechselstrom- oder Pulsgleichstromgenerator verbundene Elektroden umfasst,
a.ii) oder eine Plasmaquelle mit Hohlkatode, die mindestens eine mit einem Wechselstrom-, Gleichstrom- oder Pulsgleichstromgenerator verbundene Elektrode umfasst,
b) Anlegen einer elektrischen Leistung
b.i) entweder im Fall einer Plasmaquelle mit linearem Doppelstrahl zwischen die beiden Elektroden derart, dass die Leistungsdichte des Plasmas größer als 5 W pro cm² Plasma und kleiner oder gleich 50 W pro cm² Plasma ist,
b.ii) oder im Fall einer Plasmaquelle mit Hohlkatode an die Plasmaquelle derart, dass die Leistungsdichte des Plasmas größer als 15 kW pro Meter Plasma und kleiner oder gleich 100 kW pro Meter Plasma ist,
c) und Aufbringen eines gasförmigen Vorläufers eines organischen Silanderivats und eines Reaktivgases auf der Basis von Sauerstoff oder sauerhaltigen Derivaten auf das Substrat mit einem Volumenstrom zwischen 500 und 20.000 sccm pro linearem Meter der Plasmaquelle,
**dadurch gekennzeichnet, dass**:
(i) der Druck kleiner als 20 mTorr ist,
(ii) der Volumenstrom des gasförmigen Vorläufers eines organischen Silanderivats größer oder gleich 100 sccm pro linearem Meter der Plasmaquelle und kleiner als 400 sccm pro linearem Meter der Plasmaquelle ist,
(iii) das Verhältnis zwischen dem Volumenstrom des Sauerstoffs und dem Volumenstrom des gasförmigen Vorläufers größer als 5 ist und
(iv) die Abscheidungsgeschwindigkeit kleiner als 200 nm.m/min ist.

17. Verfahren zur Auffrischung der Glasoberfläche,
a) Bereitstellen einer PECVD-Vorrichtung mit Niederdruck, umfassend mindestens:
a.i) entweder eine Plasmaquelle mit linearem Doppelstrahl, die mindestens zwei mit einem Pulswechselstrom- oder Pulsgleichstromgenerator verbundene Elektroden umfasst,
a.ii) oder eine Plasmaquelle mit Hohlkatode, die mindestens eine mit einem Wechselstrom-, Gleichstrom- oder Pulsgleichstromgenerator verbundene Elektrode umfasst,
b) Anlegen einer elektrischen Leistung
b.i) entweder im Fall einer Plasmaquelle mit linearem Doppelstrahl zwischen die beiden Elektroden derart, dass die Leistungsdichte des Plasmas größer als 5 W pro cm² Plasma und kleiner oder gleich 50 W pro cm² Plasma ist,
b.ii) oder im Fall einer Plasmaquelle mit Hohlkatode an die Plasmaquelle derart, dass die Leistungsdichte des Plasmas größer als 15 kW pro Meter Plasma und kleiner oder gleich 100 kW pro Meter Plasma ist,
c) und Aufbringen eines gasförmigen Vorläufers eines organischen Silanderivats und eines Reaktivgases auf der Basis von Sauerstoff oder sauerhaltigen Derivaten auf das Substrat mit einem Volumenstrom zwischen 500 und 20.000 sccm pro linearem Meter der Plasmaquelle,
**dadurch gekennzeichnet, dass**:
(i) der Volumenstrom des gasförmigen Vorläufers eines organischen Silanderivats größer oder gleich 100 sccm pro linearem Meter der Plasmaquelle und kleiner als 200 sccm pro linearem Meter der Plasmaquelle ist,
(ii) die Abscheidungsgeschwindigkeit kleiner als 200 nm.m/min ist,
(iii) der Druck kleiner als 15 mTorr ist, und
(iv) das Verhältnis zwischen dem Volumenstrom des Sauerstoffs und dem Volumenstrom des gasförmigen Vorläufers größer als 5 ist.

## Claims

1. Method of producing films of metal oxides, nitrides or oxynitrides or of semiconductors on a substrate, by the PECVD method comprising the steps consisting of:
a) providing a low-pressure PECVD device, comprising at least one linear dual-beam plasma source, which comprises at least two electrodes connected to an AC or pulsed DC generator, for depositing said films on the substrate,
b) applying electric power between the two electrodes in such a way that the power density of the plasma is between 5 and 50 W per cm2 of plasma, and
c) applying a gaseous precursor of films of metal oxides, nitrides or oxynitrides or of semiconductors on the substrate at a flow rate between 100 and 500 sccm per linear metre of the plasma source, and a reactive gas based on oxygen or oxygen-containing derivatives or on nitrogen-containing derivatives at a flow rate between 500 and 20000 sccm per linear metre of the plasma source.

2. Method of producing films of metal oxides, nitrides or oxynitrides or of semiconductors on a substrate, by the PECVD method comprising the steps consisting of:
a) providing a low-pressure PECVD device, comprising at least one hollow cathode plasma source, which comprises at least one electrode connected to an AC, DC or pulsed DC generator, for depositing said films on the substrate,
b) applying electric power to the plasma source in such a way that the power density of the plasma is between 15 and 100 kW per metre of plasma, and,
c) applying a gaseous precursor of films of metal oxides, nitrides or oxynitrides or of semiconductors on the substrate at a flow rate between 100 and 500 sccm per linear metre of the plasma source, and a reactive gas based on oxygen or oxygen-containing derivatives or nitrogen-containing derivatives at a flow rate between 500 and 20000 sccm per linear metre of the plasma source.

3. Method according to Claim 1, in which, in step a), the source of the PECVD device has dimensions between 250 mm and 4000 mm in length and between 100 and 800 mm in width, supplying power between 5 kW and 50 kW per linear metre of the plasma source.

4. Method according to one of Claims 1 to 3, in which, in step a), the pressure is between 0.001 and 0.5 Torr.

5. Method according to one of Claims 1 to 4, in which, in step a), the frequencies of the AC or pulsed DC generator are between 5 and 150 kHz.

6. Method according to one of Claims 1 to 5, in which the molar ratio of reactive gas to gaseous precursor is, for films of the M^{(x)}O_{x/2} type, greater than or equal to (x/2 - y)/z, x being the valence of the metal oxide to be obtained, y being the number of oxygen atoms present in the starting precursor and z being the number of oxygen atoms present in the reactive gas.

7. Method according to one of Claims 1 to 5, in which the molar ratio of reactive gas to gaseous precursor, for films of the type M^{(x)}N_{x/3}, is greater than or equal to (x/3 - y)/z, x being the valence of the metal nitride to be obtained, y being the number of nitrogen atoms present in the starting precursor and z being the number of nitrogen atoms present in the reactive gas.

8. Method according to one of Claims 1 to 7, in which the ratio of the flow rate of the reactive gas to the flow rate of the gaseous precursor is at least 5, and advantageously between 5 and 30.

9. Method according to one of Claims 1 to 8, in which the flow rate of the gaseous precursor of films of metal oxides, nitrides or oxynitrides or of semiconductors is between 150 and 500 sccm per linear metre of plasma source.

10. Method according to one of Claims 1 to 9, in which the deposition rate is from 100 to 400 nm.m/min.

11. Method for producing a glass substrate on which a layer of SiO₂ is deposited in direct contact with the substrate, by the PECVD method comprising the steps consisting of:
a) providing a low-pressure PECVD device, comprising at least:
a.i) either a linear dual-beam plasma source, which comprises at least two electrodes connected to an AC or pulsed DC generator,
a.ii) or a hollow cathode plasma source, which comprises at least one electrode connected to an AC, DC or pulsed DC generator,
b) applying electric power
b.i) either, in the case of a linear dual-beam plasma source, between the two electrodes in such a way that the power density of the plasma is above 5 W per cm² of plasma and less than or equal to 50 W per cm² of plasma,
b.ii) or, in the case of a hollow cathode plasma source, to the plasma source in such a way that the power density of the plasma is above 15 kW per metre of plasma and less than or equal to 100 kW per metre of plasma,
c) and applying, on the substrate, a gaseous precursor of an organic silane derivative and of pure oxygen as reactive gas at a flow rate between 500 and 20000 sccm per linear metre of the plasma source,
**characterized in that**:
(i) the flow rate of the gaseous precursor of an organic silane derivative is between 100 and 500 sccm per linear metre of the plasma source
(ii) the deposition rate is below 400 nm.m/min,
(iii) the pressure of the PECVD device is between 3 and 20 mTorr,
(iv) the ratio of the flow rate of oxygen to the flow rate of the organic silane derivative is greater than 5.

12. Method for producing layers of SiO₂ deposited either directly on a glass substrate, or in a stack with other layers in any position, or else as the outermost layer of a stack for controlling the haze values in stacks intended for solar applications incorporating Low-E layers, said haze values being at least 5%, by the PECVD method comprising the steps consisting of:
a) providing a low-pressure PECVD device, comprising at least:
a.i) either a linear dual-beam plasma source, which comprises at least two electrodes connected to an AC or pulsed DC generator,
a.ii) or a hollow cathode plasma source, which comprises at least one electrode connected to an AC, DC or pulsed DC generator,
b) applying electric power
b.i) either, in the case of a linear dual-beam plasma source, between the two electrodes,
b.ii) or, in the case of a hollow cathode plasma source, to the plasma source,
c) and applying, on the substrate, a gaseous precursor of an organic silane derivative and a reactive gas based on oxygen or oxygen-containing derivatives at a flow rate between 500 and 20000 sccm per linear metre of the plasma source,
**characterized in that**:
(i) the power applied in step b) is such that the power density of the plasma is between 5 and 10 W per cm² of plasma for a linear dual-beam plasma source or between 15 and 20 kW per metre of plasma for a hollow cathode plasma source,
(ii) the flow rate of the gaseous precursor of an organic silane derivative is greater than or equal to 100 sccm per linear metre of plasma and below 400 sccm per linear metre of plasma source,
(iii) the ratio of the flow rate of oxygen to the flow rate of the gaseous precursor is greater than 5, and
(iv) the deposition rate is below 400 nm.m/min.

13. Method for producing layers of SiO₂ deposited either directly on a glass substrate, or in a stack with other layers in any position, or else as the outermost layer of a stack for controlling the haze values in stacks intended for solar applications incorporating Low-E layers, said haze values being below 0.5%, by the PECVD method comprising the steps consisting of:
a) providing a low-pressure PECVD device, comprising at least:
a.i) either a linear dual-beam plasma source, which comprises at least two electrodes connected to an AC or pulsed DC generator,
a.ii) or a hollow cathode plasma source, which comprises at least one electrode connected to an AC, DC or pulsed DC generator,
b) applying electric power
b.i) either, in the case of a linear dual-beam plasma source, between the two electrodes in such a way that the power density of the plasma is between 5 and 50 W per cm² of plasma,
b.ii) or, in the case of a hollow cathode plasma source, to the plasma source in such a way that the power density of the plasma is between 15 and 100 kW per metre of plasma,
c) and applying, on the substrate, a gaseous precursor of an organic silane derivative and a reactive gas based on oxygen or oxygen-containing derivatives at a flow rate between 500 and 20000 sccm per linear metre of the plasma source,
**characterized in that**:
(i) the pressure is above 5 mTorr,
(ii) the flow rate of the gaseous precursor of an organic silane derivative is greater than or equal to 100 sccm per linear metre of plasma source and below 400 sccm per linear metre of plasma source,
(iii) the ratio of the flow rate of oxygen to the flow rate of the gaseous precursor is greater than 15, and
(iv) the deposition rate is below 400 nm.m/min.

14. Method for producing layers selected from the group consisting of SiO₂, ZrO₂ and Al₂O₃, deposited either directly on a glass substrate, or as the outermost layer of a stack with the aim of imparting anti-scratch properties to the coated or uncoated substrate, by the PECVD method comprising the steps consisting of:
a) providing a low-pressure PECVD device, comprising at least:
a.i) either a linear dual-beam plasma source, which comprises at least two electrodes connected to an AC or pulsed DC generator,
a.ii) or a hollow cathode plasma source, which comprises at least one electrode connected to an AC, DC or pulsed DC generator,
b) applying electric power
b.i) either, in the case of a linear dual-beam plasma source, between the two electrodes in such a way that the power density of the plasma is between 10 and 40 W per cm2 of plasma,
b.ii) or, in the case of a hollow cathode plasma source, to the plasma source in such a way that the power density of the plasma is between 20 and 50 kW per metre of plasma,
c) and applying, on the substrate, a gaseous precursor of films of metal oxides or of semiconductors and a reactive gas based on oxygen or oxygen-containing derivatives at a flow rate between 500 and 20000 sccm per linear metre of the plasma source,
**characterized in that**:
(i) the pressure is below 10 mTorr,
(ii) the flow rate of the gaseous precursor of films of metal oxides or of semiconductors is between 150 and 500 sccm per linear metre of plasma source,
(iii) the ratio of the flow rate of oxygen to the flow rate of the gaseous precursor is greater than 10, and
(iv) the deposition rate is below 400 nm.m/min.

15. Method for producing stacks on a glass substrate having anti-reflective (AR) properties, said stack comprising a succession of layers with high refractive indices and low refractive indices, by the PECVD method comprising the steps consisting of:
a) providing a low-pressure PECVD device, comprising at least:
a.i) either a linear dual-beam plasma source, which comprises at least two electrodes connected to an AC or pulsed DC generator,
a.ii) or a hollow cathode plasma source, which comprises at least one electrode connected to an AC, DC or pulsed DC generator,
b) applying electric power
b.i) either, in the case of a linear dual-beam plasma source, between the two electrodes in such a way that the power density of the plasma is between 10 and 40 W per cm2 of plasma,
b.ii) or, in the case of a hollow cathode plasma source, to the plasma source in such a way that the power density of the plasma is between 20 and 50 kW per metre of plasma,
c) and applying, on the substrate, a gaseous precursor of an organic silane derivative and a reactive gas based on oxygen or oxygen-containing derivatives at a flow rate between 500 and 20000 sccm per linear metre of the plasma source,
**characterized in that**:
(i) the pressure is below 20 mTorr,
(ii) the flow rate of the gaseous precursor of an organic silane derivative is greater than or equal to 100 sccm per linear metre of plasma and below 400 sccm per linear metre of plasma source,
(iii) the ratio of the flow rate of oxygen to the flow rate of the gaseous precursor is greater than 5, and
(iv) the deposition rate is below 400 nm.m/min.

16. Method for producing a transparent layer of SiO₂ deposited on a glass substrate coated with a Low-E layer, by the PECVD method comprising the steps consisting of:
a) providing a low-pressure PECVD device, comprising at least:
a.i) either a linear dual-beam plasma source, which comprises at least two electrodes connected to an AC or pulsed DC generator,
a.ii) or a hollow cathode plasma source, which comprises at least one electrode connected to an AC, DC or pulsed DC generator,
b) applying electric power
b.i) either, in the case of a linear dual-beam plasma source, between the two electrodes in such a way that the power density of the plasma is above 5 W per cm2 of plasma and less than or equal to 50 W per cm2 of plasma,
b.ii) or, in the case of a hollow cathode plasma source, to the plasma source in such a way that the power density of the plasma is above 15 kW per metre of plasma and less than or equal to 100 kW per metre of plasma,
c) and applying, on the substrate, a gaseous precursor of an organic silane derivative and a reactive gas based on oxygen or oxygen-containing derivatives at a flow rate between 500 and 20000 sccm per linear metre of the plasma source,
**characterized in that**:
(i) the pressure is below 20 mTorr,
(ii) the flow rate of the gaseous precursor of an organic silane derivative is greater than or equal to 100 sccm per linear metre of plasma and below 400 sccm per linear metre of plasma source,
(iii) the ratio of the flow rate of oxygen to the flow rate of the gaseous precursor is greater than 5, and
(iv) the deposition rate is below 200 nm.m/min.

17. Method for refreshing the surface of glass,
a) providing a low-pressure PECVD device, comprising at least:
a.i) either a linear dual-beam plasma source, which comprises at least two electrodes connected to an AC or pulsed DC generator,
a.ii) or a hollow cathode plasma source, which comprises at least one electrode connected to an AC, DC or pulsed DC generator,
b) applying electric power
b.i) either, in the case of a linear dual-beam plasma source, between the two electrodes in such a way that the power density of the plasma is above 5 W per cm2 of plasma and less than or equal to 50 W per cm2 of plasma,
b.ii) or, in the case of a hollow cathode plasma source, to the plasma source in such a way that the power density of the plasma is above 15 kW per metre of plasma and less than or equal to 100 kW per metre of plasma,
c) and applying, on the substrate, a gaseous precursor of an organic silane derivative and a reactive gas based on oxygen or oxygen-containing derivatives at a flow rate between 500 and 20000 sccm per linear metre of the plasma source,
**characterized in that**:
(i) the flow rate of the gaseous precursor of an organic silane derivative is greater than or equal to 100 sccm per linear metre of plasma and below 200 sccm per linear metre of plasma source,
(ii) the deposition rate is below 200 nm.m/min,
(iii) the pressure is below 15 mTorr, and
(iv) the ratio of the flow rate of oxygen to the flow rate of the gaseous precursor is greater than 5.
